(19) **Europäisches Patentamt**
**European Patent Office**
**Office européen des brevets**

(11) **EP 4 300 109 A1**

(12) **EUROPEAN PATENT APPLICATION**
published in accordance with Art. 153(4) EPC

(43) Date of publication:
**03.01.2024 Bulletin 2024/01**

(21) Application number: **22825381.1**

(22) Date of filing: **17.06.2022**

(51) International Patent Classification (IPC):
*G01R 31/367* (2019.01)  *G01R 31/392* (2019.01)
*G01R 31/36* (2020.01)  *G01R 31/382* (2019.01)

(52) Cooperative Patent Classification (CPC):
**G01R 31/36; G01R 31/367; G01R 31/382;**
**G01R 31/392; G01R 31/396; G06N 20/00;**
**H01M 10/42; H01M 10/48;** Y02E 60/10

(86) International application number:
**PCT/KR2022/008648**

(87) International publication number:
**WO 2022/265458 (22.12.2022 Gazette 2022/51)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **18.06.2021 KR 20210079389**

(71) Applicant: **Lg Chem, Ltd.**
**Seoul 07336 (KR)**

(72) Inventors:
• **KONG, Changsun**
  **Daejeon 34122 (KR)**
• **KIM, Sunmin**
  **Daejeon 34122 (KR)**
• **LEE, Kyu Hwang**
  **Daejeon 34122 (KR)**

(74) Representative: **Hoffmann Eitle**
**Patent- und Rechtsanwälte PartmbB**
**Arabellastraße 30**
**81925 München (DE)**

(54) **DEVICE AND METHOD FOR PREDICTING LOW VOLTAGE FAILURE OF SECONDARY BATTERY, AND BATTERY CONTROL SYSTEM COMPRISING SAME DEVICE**

(57) The present invention relates to an apparatus and a method of predicting a low-voltage failure of a secondary battery.

[Figure 3]

**Description**

[Technical Field]

This application claims priority to and the benefit of Korean Patent Application No. 10-2021-0079389 filed in the Korean Intellectual Property Office on June 18, 2021, the entire contents of which are incorporated herein by reference.
The present invention relates to an apparatus and a method of predicting a low-voltage failure of a secondary battery, and a battery control system including the apparatus.

[Background Art]

The demand for secondary batteries in electric vehicles, mobile devices, and the like is expanding rapidly, and the need for condition diagnosis and quality reliability of secondary batteries is increasing. In response to this need, methods are being utilized to improve the quality reliability of secondary batteries by predicting and responding to low-voltage failures of secondary batteries in production or in use.
This means not only predicting and responding to low-voltage failures in secondary batteries used in electric vehicles, mobile devices, and the like but also predicting low-voltage failures in secondary batteries during quality inspection in the production process to prevent defective products from leaking out, thereby increasing the quality reliability of secondary batteries.
Specifically, the degree to which the operating voltage or open-circuit voltage (OCV) drops during the charging/discharging process is used as a criterion to predict the occurrence of low-voltage failures in secondary batteries in production or in use.
However, these existing methods require a lot of data to determine the criteria for a low-voltage failure, and new data is required to determine the criteria for low-voltage failure whenever manufacturing conditions change, so it takes a considerable amount of time to determine the low-voltage failure. Further, the existing method also has disadvantages in that the accuracy in the determination is not high.
Therefore, there is a need for a method that can reduce the time to determine whether a low-voltage failure has occurred while improving the accuracy of the determination, and an apparatus that can implement the method.

[Patent Document]

Korean Patent Application Laid-Open No. 10-2015-0049528

[Detailed Description of the Invention]

[Technical Problem]

The present invention provides an apparatus and a method of predicting a low-voltage failure of a secondary battery by correcting an influence of a usage condition of a battery, and a battery control system including the apparatus.

[Technical Solution]

An exemplary embodiment of the present invention provides an apparatus for predicting a low-voltage failure of a secondary battery, the apparatus including: a first training data input unit for receiving first training data of a secondary battery measured during a specific time period of charging, discharging, and resting processes of an individual secondary battery selected as a first training target; a first measurement data input unit for receiving first measurement data of a secondary battery selected during a specific time period of the charging, discharging, and resting processes of a secondary battery selected as a first prediction target; a first data learning unit for generating a low-voltage prediction model of a first secondary battery by performing machine learning on the first training data of the secondary battery input to the first training data input unit and selecting a main factor among the first training data; a first verification unit for comparing a low-voltage determination prediction result of the secondary battery in which the first measurement data is applied to the low-voltage prediction model of the first secondary battery generated from the first data learning unit with an actual low-voltage determination prediction result of the secondary battery of the first measurement data and finding an optimal value of a weighting factor k that maximizes performance of the low-voltage prediction model of the first secondary battery to verify and optimize the low-voltage prediction model of the first secondary battery; a model transferring unit for receiving the optimized low voltage prediction model of the first secondary battery and the optimal value of the weighting factor k; a second training data input unit for receiving second training data of a secondary battery measured during a specific time period of charging, discharging, and resting processes of an individual secondary battery selected as a second training target; a second measurement data input unit for receiving second measurement data of a secondary battery selected during a specific time period of the charging, discharging, and resting processes of a secondary battery selected as a second prediction target; a second data learning unit for generating a low-voltage prediction model of a second secondary battery by performing machine learning on the optimized low-voltage prediction model of the first secondary battery transferred to the model transferring unit and the second training data of the secondary battery input to the second training data input unit; and a second output unit for outputting a low-voltage determination prediction result of the secondary battery in which the second measurement data is applied to the low-voltage prediction model of the second secondary battery generated from the second data learning unit, in which process conditions of the secondary battery selected as the first training target and the first prediction target are different from process conditions of the secondary battery selected as the second training target and the second prediction target.

Another exemplary embodiment of the present invention provides a method of predicting a low-voltage failure of a secondary battery, the method including: inputting first training data of a secondary battery measured during a specific time period of charging, discharging, and resting processes of an individual secondary battery selected as a first training target; generating a low-voltage prediction model of a first secondary battery by performing machine learning on the first training data and selecting a main factor from the first training data; inputting first measurement data of the secondary battery selected during a specific time period of charging, discharging, and resting processes of a secondary battery selected as a first prediction target; comparing a low-voltage determination prediction result of the secondary battery in which the first measurement data is applied to the generated low-voltage prediction model of the first secondary battery with actual low-voltage determination prediction result of the secondary battery of the first measurement data and finding an optimal value of a weighting factor k that maximizes performance of the low-voltage prediction model of the first secondary battery to verify and optimize the low-voltage prediction model of the first secondary battery; transferring the optimized low-voltage prediction model of the first secondary battery and the optimum value of the weighting factor k; inputting second training data of a secondary battery measured during a specific time period of charging, discharging, and resting processes of an individual secondary battery selected as a second training target; generating a low-voltage prediction model of a second secondary battery by performing machine learning on the low-voltage prediction model of the optimized transferred first secondary battery and the second training data; inputting second measurement data of a secondary battery selected during a specific time period of charging, discharging, and resting processes of a secondary battery selected as a second prediction target; and outputting a low-voltage determination prediction result of the secondary battery in which the second measurement data is applied to the low-voltage prediction model of the second secondary battery generated from the second data learning unit, in which process conditions of the secondary batteries selected as the first training target and the first prediction target are different from process conditions of the secondary battery selected as the second training target and the second prediction target.

Another exemplary embodiment of the present invention provides a battery management system apparatus including the apparatus for predicting the low-voltage failure of the secondary battery.

Another exemplary embodiment of the present invention provides a mobile device including the battery management system apparatus.

Finally, another exemplary embodiment of the present invention provides a computer program stored in a recording medium executing the method of predicting the low-voltage failure of the secondary battery.

[Advantageous Effects]

The apparatus and the method according to the exemplary embodiments of the present invention may improve the accuracy of determining a low-voltage failure of a secondary battery, which may result in process cost savings.

The apparatus and the method according to the exemplary embodiments of the present invention may reduce the time required to determine a low-voltage failure of a secondary battery and minimize the risk of failure by enabling early detection and response to low-voltage failures.

[Brief Description of Drawings]

FIG. 1 is a diagram illustrating a confusion matrix for obtaining FDR, FOR, and MER.
FIG. 2 is a diagram illustrating a process of predicting a low-voltage failure of an apparatus and a method of predicting a low-voltage failure of a secondary battery in the related art.
FIGS. 3 to 7 are diagrams illustrating a process of predicting a low-voltage failure of an apparatus and a method of predicting a low-voltage failure of a secondary battery according to an exemplary embodiment of the present invention.
FIG. 8 is a diagram illustrating a process of obtaining an optimal value of a weighting factor k to minimize a Misclassification Error Rate (MER).

FIG. 9 is a diagram illustrating a comparison of the MER values of an example with a transfer learning process and a comparative example without a transfer learning process.

[Best Mode]

Hereinafter, the present invention will be described in detail so that those skilled in the art to which the present invention belongs may readily practice the present invention. However, the invention may be implemented in many different forms and is not limited to the configuration described herein.

In the present specification, when a part "includes" a certain constituent element, it means that other constituent elements may be further included, rather than excluding other constituent elements, unless explicitly described to the contrary.

That is, in the present specification, "training data" means data for machine learning.

Also, in the present specification, "measurement data" means data that is input to calculate "prediction data," and the prediction data means data that is output as a result of applying machine learning to the input measurement data.

In the present specification, "low-voltage failure" refers to a sudden irreversible drop in the voltage of an in-use secondary battery over a short period of time, and is distinguished from the normal performance degradation of a secondary battery over time. Criteria for low-voltage failure are predefined according to the quality standards set for each type of secondary battery.

An exemplary embodiment of the present invention provides an apparatus for predicting a low-voltage failure of a secondary battery, the apparatus including: a first training data input unit for receiving first training data of a secondary battery measured during a specific time period of charging, discharging, and resting processes of an individual secondary battery selected as a first training target; a first measurement data input unit for receiving first measurement data of a secondary battery selected during a specific time period of the charging, discharging, and resting processes of a secondary battery selected as a first prediction target; a first data learning unit for generating a low-voltage prediction model of a first secondary battery by performing machine learning on the first training data of the secondary battery input to the first training data input unit and selecting a main factor among the first training data; a first verification unit for comparing a low-voltage determination prediction result of the secondary battery in which the first measurement data is applied to the low-voltage prediction model of the first secondary battery generated from the first data learning unit with an actual low-voltage determination prediction result of the secondary battery of the first measurement data to verify and optimize the low-voltage prediction model of the first secondary battery; a model transferring unit for receiving the optimized low voltage prediction model of the first secondary battery; a second training data input unit for receiving second training data of a secondary battery measured during a specific time period of charging, discharging, and resting processes of an individual secondary battery selected as a second training target; a second measurement data input unit for receiving second measurement data of a secondary battery selected during a specific period of the charging, discharging, and resting processes of a secondary battery selected as a second prediction target; a second data learning unit for generating a low-voltage prediction model of a second secondary battery by performing machine learning on the optimized low-voltage prediction model of the first secondary battery transferred to the model transferring unit and the second training data of the secondary battery input to the second training data input unit; and a second output unit for outputting a low-voltage determination prediction result of the secondary battery in which the second measurement data is applied to the low-voltage prediction model of the second secondary battery generated from the second data learning unit, in which process conditions of the secondary battery selected as the first training target and the first prediction target are different from process conditions of the secondary battery selected as the second training target and the second prediction target.

The apparatus for predicting the low-voltage failure of the secondary battery of the present invention may reduce the time required to accumulate or collect data to establish determination criteria for predicting and diagnosing (prognosis) whether a low-voltage failure occurs or a large amount of new data whenever a battery model changes or manufacturing conditions and the like change, so that when the apparatus for predicting the low-voltage failure of the secondary battery of the present invention is applied to secondary batteries with different process conditions, it is possible to reduce the time required to determine a low-voltage failure of a secondary battery and minimize the risk of failure by detecting and responding to a low-voltage failure earlier.

In the exemplary embodiment, a battery selected as a training target and a battery selected as a prediction target may refer to individual batteries that are independently placed on a module, a pack, or a tray, respectively.

In the exemplary embodiment, a battery selected as a training target and a battery selected as a prediction target may refer to individual batteries that are independently placed on a module, a pack, or a tray, respectively.

Herein, machine learning is one field of artificial intelligence that refers to the improvement of the information processing ability of computer programs by learning using data and processing experience, or techniques related to it. Techniques related to machine learning are well known in the art to which the present invention belongs. That is, a detailed description of a particular learning algorithm for machine learning will be omitted.

Specifically, each of the machine learning of the first data learning unit and the second data learning unit of the apparatus for predicting the low-voltage failure of the secondary battery according to the exemplary embodiment of the present invention may independently apply one or more methods selected from, but not limited to, decision tree, random Forest, neural network, deep neural network, support vector machine, and gradient boosting machine.

Also, in the present specification, "training data" and "measurement data" refer to data for accurately predicting a low-voltage failure of a secondary battery by using machine learning, and means data including a charging voltage of the battery, a discharging voltage of the battery, a charging current of the battery, a discharging current of the battery, a charging capacity of the battery, a discharging capacity of the battery, an impedance of the battery, a temperature of the battery, and the like that are measured, collected, and stored during the charging, discharging, and resting states of the battery, and may include all factors that may be measured and collected during the charging, discharging, and resting states of the battery.

Specifically, each of the first training data of the secondary battery, the first measurement data of the secondary battery, the second training data, and the second measurement data of the secondary battery of the apparatus for predicting the low-voltage failure of the secondary battery according to the exemplary embodiment of the present invention may refer to, but are not limited to, at least one measurement value selected from a voltage measurement value of the battery, a current measurement value of the battery, an impedance measurement value of the battery, a temperature measurement value of the battery, a capacity measurement value of the battery, and a power measurement value of the battery that are measured in the charging, discharging, and resting processes of the secondary battery independently.

Also, more specifically, "measurement data" may mean data including only data that have been selected as "main factors" in the "training data". Herein, "main factors" may include an average value of the charge voltages, an average value of the discharging voltages, a charge temperature measurement value, a discharge temperature measurement value, a charge capacity measurement value, a discharge capacity measurement value, a charge power measurement value, a discharge power measurement value, and an electrical impedance measurement value measured during some or all of a specific charging process and a specific discharging process section, but the number and types of the main factors may be the same or different depending on the type of battery, and are not limited to the types of the main factors.

Further, the main factor may include, but is not limited to, a deviation between an open circuit voltage (OCV) value measured at the start of the resting process and an OCV value measured at the end of the resting process in a resting process section between a specific charging process and a specific discharging process, as represented by Equation 1 below.

$$[\text{Equation 1}]$$

$$D = |OCV1 - OCV2|$$

In Equation 1 above, OCV1 means the open circuit voltage value measured at the start of the resting process, OCV2 means the open circuit voltage value measured at the end of the resting process, | | means the absolute value, and D means the deviation between the open circuit voltage (OCV) value measured at the start of the resting process and the open circuit voltage (OCV) value measured at the end of the resting process.

The above main factors correspond to data that are easy to collect in the charging, discharging, and resting processes of the secondary battery, and by selecting the above main factors and using the selected main factors as the measurement data, it is possible to improve accuracy of the prediction of the low-voltage failure of the secondary battery and reduce the time required for the prediction.

The measurement values may be measured by devices, techniques, and methods of ordinary skill in the art.

In the present specification, unless otherwise noted, the battery is a secondary battery.

In the present specification, "specific time" means an arbitrarily determined time for the charging and discharging process of the secondary battery. For example, in the case where the charging and discharging process of the secondary battery is scheduled to be performed for one hour, a specific time means one hour.

The verification and the optimization of the low-voltage prediction model of the first secondary battery of the first verification unit of the apparatus for predicting the low-voltage failure of the secondary battery according to the present invention includes finding an optimal value of the weighting factor k that may maximize the performance of the low voltage prediction model of the first secondary battery, and the optimal value of the weighting factor k may mean a value that may minimize a Misclassification Error Rate (MER).

In the present specification, an MER means the ratio of the total number of batteries that are erroneously determined, i.e., the batteries determined as defective even though the batteries are normal, or the batteries determined as normal even though the batteries are defective, with respect to the total number of batteries that are determined as normal/defective.

More specifically, different probabilistic weighting factors may be assigned to a normal battery class and a defective battery class included in the data, and a threshold value (k) for the weighting factor that maximizes the accuracy of the model is introduced. In this case, the threshold value of the weighting factor means the optimal value of the weighting factor k, where k is a real number greater than 0 and less than 1 (0<k<1).

More specifically, there are concepts of a False Discovery Rate (FDR) and a False Omission Rate (FOR), which are indexes of prediction performance for normal/defect predictions.

Herein, the FDR is the ratio of the total number of batteries that are ultimately determined to be defective as a result of the determination with respect to the number of batteries determined as normal, and the FOR is the ratio of the number of batteries ultimately determined as normal with respect to the total number of batteries determined as defective.

Based on these definitions, in order to reduce the value of any one of the FDR and the FOR, an increase in the value of the other is usually involved, so that there is a trade-off between FDR and FOR.

The apparatus for predicting the low-voltage failure of the secondary battery according to the present invention seeks to minimize both the FDR and the FOR, which means minimizing a Misclassification Error Rate (MER).

In this case, the FDR, the FOR, and the MER may be expressed as Equation 2 to Equation 4 below.

[Equation 2]

$$\text{MER}(\%) = \{(FP + FN) / (TP + TN + FP + FN)\} \times 100(\%)$$

[Equation 3]

$$\text{FDR}(\%) = \{FP / (TP + FP)\} \times 100(\%)$$

[Equation 4]

$$\text{FOR}(\%) = \{FN / (TN + FN)\} \times 100(\%)$$

The definitions of TP, FP, TN, and FN in Equations 2 to 4 above are as follows.

- TP=True Positive : The case where a normal battery is correctly predicted to be normal
- FP=False Positive : The case where a defective battery is incorrectly predicted to be normal
- TN=True Negative : The case where a defective battery is correctly predicted to be defective
- FN=False Negative : The case where a normal battery is incorrectly predicted to be defective

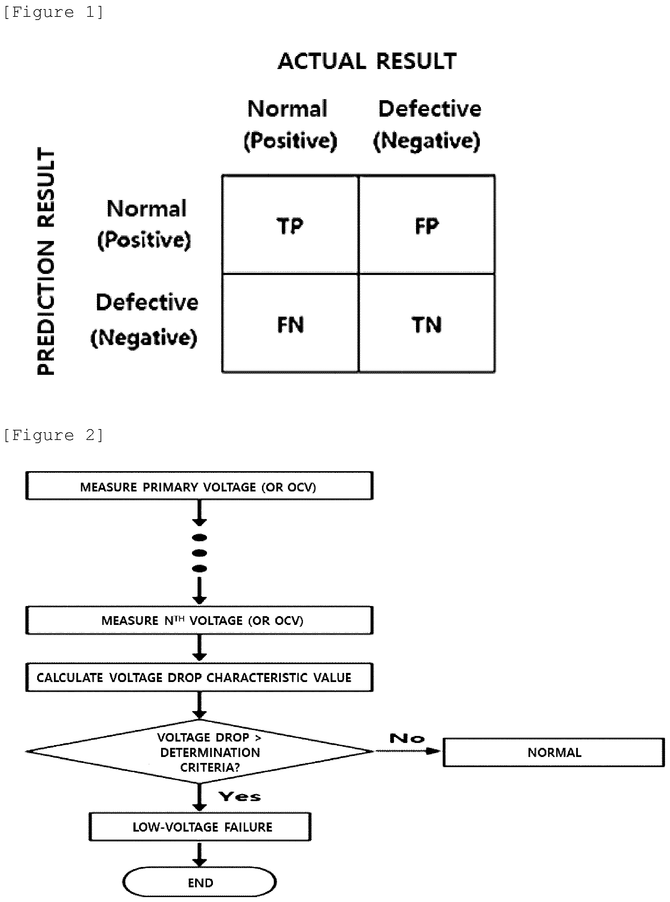

Specifically, for the FDR, the FOR, and the MER, the ratio corresponding to each of four divided items of the case where a normal battery is correctly predicted to be normal (TP), the case where a defective battery is incorrectly predicted to be normal (FN), The case where a normal battery is incorrectly predicted to be defective (FP), the case where a defective battery is correctly predicted to be defective (TN) may be calculated as a probability by using the confusion matrix as illustrated in FIG. 1.

As a result, the FDR and FOR according to the change in the value of the weighting factor k are calculated, and the value of k that minimizes both index values is determined as the optimal value of the weighting factor k.

The reason why the optimization process is necessary is to improve accuracy of the model by considering the corresponding ratio because the ratio of the normal batteries and the low-voltage defective batteries among the secondary batteries produced under the same conditions is different. For example, the value of the optimized weighting factor k in a particular domain where the number of normal batteries is much larger than the number of defective batteries may reflect the characteristics of the prediction model in the domain, although the value of the optimized weighting factor k may vary due to various reasons, such as battery configuration, and production methods and equipment.

The apparatus for predicting the low-voltage failure of the secondary battery of the present invention may further include a first output unit for outputting a low-voltage determination prediction result of the secondary battery in which the first measurement data is applied to the low-voltage prediction model of the first secondary battery generated from the first data learning unit.

The apparatus for predicting the low-voltage failure of the secondary battery of the present invention may further include a second verification unit for verifying the low voltage prediction model of the second secondary battery by comparing the low voltage determination prediction result of the secondary battery in which the second measurement data is applied to the low voltage prediction model of the second secondary battery generated by the second data learning unit and the actual low voltage determination result of the secondary battery of the second measurement data.

In the present specification, the "input unit" is an interface for receiving an input of various necessary data. Specifically, in the present specification, the input unit may be divided into a training data input unit that receives training data and a measurement data input unit that receives measurement data. More specifically, the "input part" is an interface for measuring or collecting a capacity factor measured or collected under a rated capacity condition, and transmitting the measured or collected capacity factor measurement data to a reference value storage unit or the data learning unit. The method in which the learning unit receives and transmits data is not specifically limited.

In the present specification, the "data learning unit" is an interface for performing machine learning by using the training data input to the training data input unit.

In the present specification, the "output unit" is an interface for calculating prediction data reflecting the results of machine learning. The method in which the output unit calculates data is not particularly limited.

In the present specification, the "verification unit" is an interface for performing a process of determining the accuracy of the prediction data of the low-voltage failure prediction model of the secondary battery reflecting the results of machine learning and, in some cases, optimizing the low-voltage failure prediction model of the secondary battery.

In the present specification, the "model transferring unit" is an interface for transferring the model as data to use the low-voltage failure prediction model of the secondary battery derived by reflecting the result of machine learning in the case of predicting the low-voltage failure of the secondary battery under a condition different from the existing condition, or for transferring the optimal value of the weighting factor k that may maximize the performance of the model. Specifically, the model transferring unit performs a function of receiving information about a machine learning model that has been modeled under a specific condition, for example, information about the structure of the model, information about the probabilistic distribution of the training data, and information about the main factors, including a weighting factor k value to minimize the MER, and enabling the received function to be used when performing machine learning on the secondary battery data under a different condition.

The interface according to the present invention is not particularly limited in manner and form, as long as the interface is capable of performing the prescribed functions.

All data input and transmitted to or calculated in the interface of the apparatus according to the present invention may be managed in a unified manner. Herein, integrally managing may include, for example, managing all data input and transmitted to or calculated in the interface of the device according to the present invention by a specific main computer or server, calculating new values from the managed data, or inputting the new value into the input unit as data again.

FIG. 2 is a diagram illustrating a process of predicting a low-voltage failure of an apparatus for predicting a low-voltage failure of a secondary battery in the related art, and in the related art, the degree to which the operating voltage or open circuit voltage (OCV) drops during the charging/discharging process is used as a determination criteria, and when a voltage drop characteristic value calculated by measuring the $N^{th}$ voltage or open circuit voltage satisfies the determination criteria, the battery is determined to have a low-voltage failure. Herein, N is an integer equal to or greater than 1.

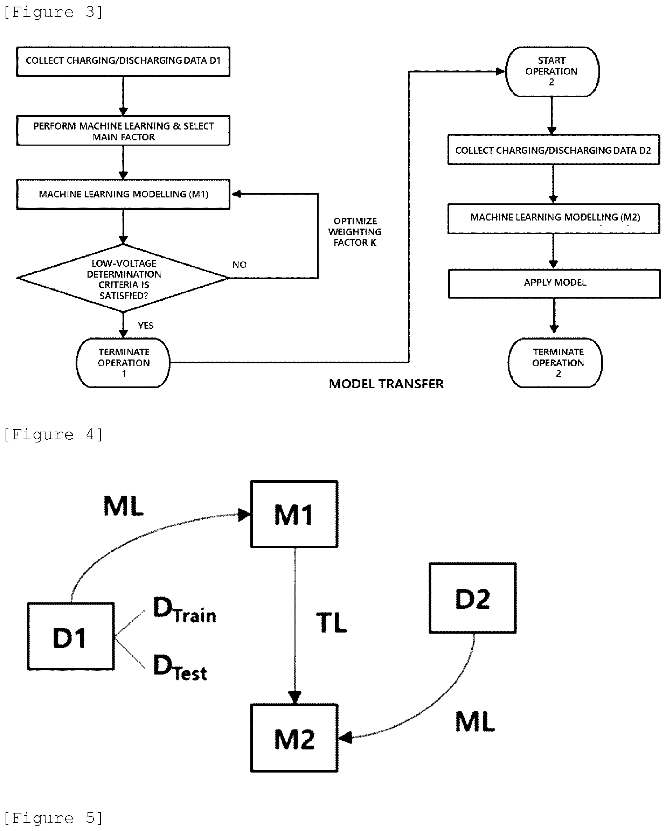

FIG. 3 is a diagram illustrating a process of predicting a low-voltage failure of an apparatus for predicting a low-voltage failure of a secondary battery according to an exemplary embodiment of the present invention, and specifically, the apparatus for predicting the low-voltage failure of the secondary battery according to the exemplary embodiment of the present invention first collects charging and discharging data D1 corresponding to first training data and first measurement data for a secondary battery under a predetermined condition, performs machine learning with the collected data D1, selects a main factor for predicting a low-voltage failure from the data, and then primarily calculates a low voltage prediction model of a first secondary battery through machine learning modeling. In order to satisfy the condition of minimizing the misclassification error rate (MER), which is the determination criteria of the apparatus for predicting the low-voltage failure of the secondary battery of the present invention, a weighting factor k optimization process is performed to determine an optimal value of the weighting factor and optimize the low voltage prediction model of the first secondary battery (termination of Operation 1). The optimized model may be used to predict the low-voltage failure of a secondary battery for which the first training data and the first measurement data have been collected.

Subsequently, the optimized low voltage prediction model of the first secondary battery is model-transferred, and the low voltage prediction model of the first secondary battery may be used to predict the low-voltage failure of the secondary battery under a different condition from that of the case of data D1 (start Operation 2). Charging and discharging data D2 corresponding to second training data of the secondary battery under the different condition from that of the case of data D1 is collected, and a low voltage prediction model of a second secondary battery is calculated through machine learning modeling with the collected data D2. In this case, the low voltage prediction model of the first secondary battery transferred in the process of calculating the low voltage prediction model of the second secondary battery is used. When the low-voltage prediction model of the second secondary battery is calculated, the second measurement data of the secondary battery under the different condition from that of the case of data D1 may be applied to the low-

voltage prediction model of the second secondary battery to predict the low-voltage failure of the corresponding secondary battery (termination of Operation 2).

FIG. 4 is a diagram more schematically illustrating the process of predicting the low-voltage failure of the apparatus for predicting the low-voltage failure of the secondary battery according to the exemplary embodiment of the present invention, and machine learning ML is performed with the first training data Dtrain that is the machine learning data of a source domain and the charging/discharging data D1 corresponding to the first measurement data Dtest to generate a low-voltage failure prediction model M1 of the source domain, the generated M1 is transferred and trained TL, and the machine learning ML is performed with the charging/discharging data D2 corresponding to the second training data that is the machine learning data of a target domain.

The apparatus for predicting the low-voltage failure of the secondary battery of the present invention is characterized in transferring and using a previously generated low-voltage failure prediction model, thereby reducing the time for generating the prediction model. In other words, for example, even though the data D2 of the target domain is smaller than the data D1 of the source domain as illustrated in FIG. 5, when the characteristics of the two domains are similar to each other, it is possible to improve the performance of the model M2 with high accuracy by utilizing the information of the prediction model M1 even though the model M2 is trained with the small-sized data.

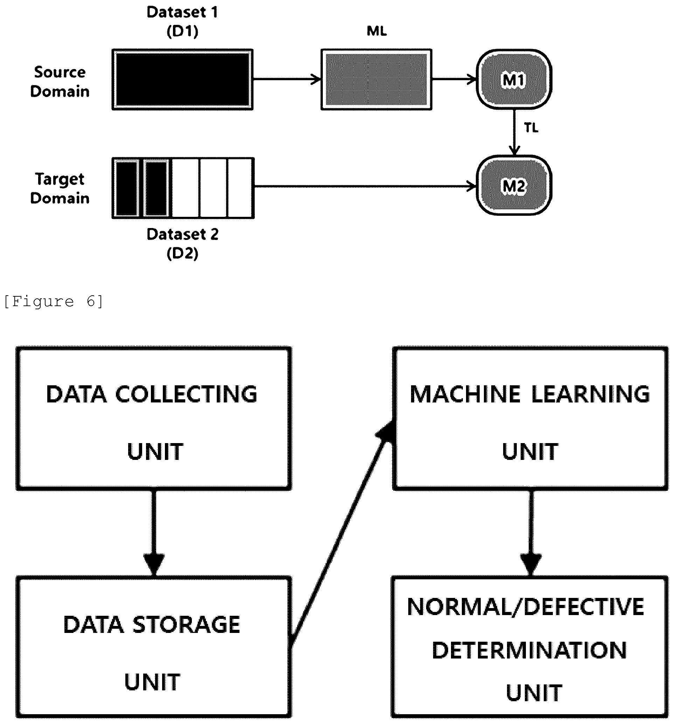

The more approximate configuration of the apparatus for predicting the low-voltage failure of the secondary battery of the present invention is illustrated in FIG. 6.

Specifically, a unit for collecting data in order to input the data to the first training data input unit, the first measurement data input unit, the second training data input unit, and the second measurement data input unit of the present invention may be referred to as a data collection unit. In order to collect the above data, a sensor unit capable of measuring the characteristics of the target secondary battery may be further included.

Further, the first training data input unit, the first measurement data input unit, the second training data input unit, and the second measurement data input unit may correspond to the data storage unit of FIG. 6, and specifically, the storage unit may be divided into an area where data for machine learning is stored and an area where data for new determination is stored. More specifically, for the data D1 for machine learning of the source domain, the data consists of the main factors (Xs,1) for determining whether the battery has the low-voltage failure, and the determination result (Y1). On the other hand, for the data D2 of the target domain, the data consists of only the main factors (Xs,2) and the determination result (Y2) is not included in the data.

The machine learning unit (computing unit) may correspond to the first learning unit and the second learning unit of the apparatus for predicting the low-voltage failure of the secondary battery of the present invention, and consists of a unit containing a machine learning algorithm and a unit for computing and evaluating the importance of variables during machine learning.

A normal/defect determination unit may correspond to the first verification unit and the second verification unit of the apparatus for predicting the low-voltage failure of the secondary battery of the present invention, and is a unit that predicts whether the battery is normal/defective for newly input data. The corresponding unit may be updated with new models whenever the data for machine learning is updated.

The normal/defect determination unit may be updated with new models whenever the data for machine learning is updated, so that it is possible to improve accuracy of the prediction of the low-voltage failure of the secondary battery.

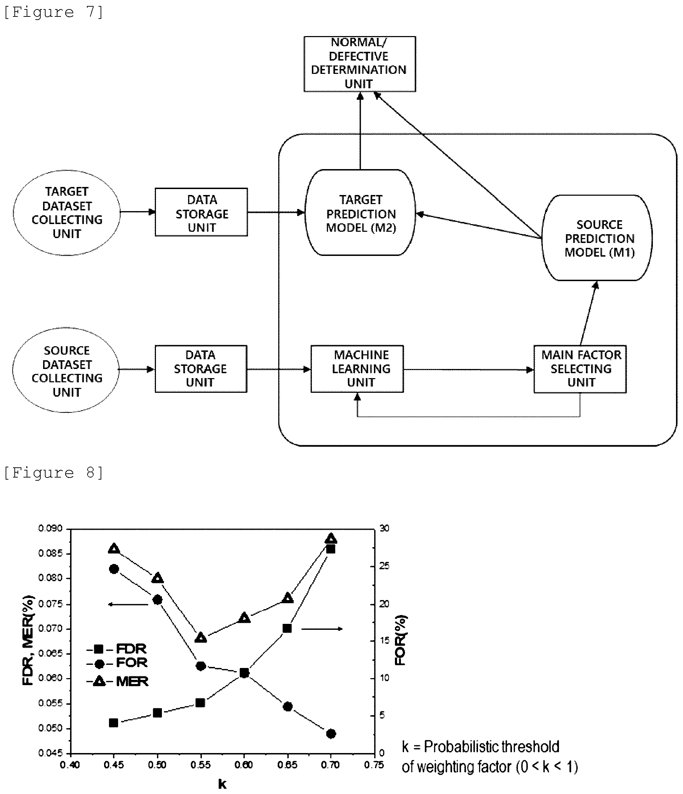

A more detailed representation of the foregoing contents is illustrated in FIG. 7 below.

As illustrated in FIG. 7, the data collection unit continuously measures/collects measurement values, such as voltage, current, impedance, temperature, capacity, and power during charging/discharging/rest of the battery and stores the measured/collected measurement values in the storage unit (storage medium). The computing unit receives the stored data values for machine learning, and evaluates and selects main factors for predicting low-voltage failures, and then generates a model. When the prediction performance of the model is verified, the corresponding model becomes the low-voltage prediction model M1 for the source domain and is used to predict whether the battery class corresponding to the source domain is normal or has the low-voltage failure. When a prediction model is needed for a new battery with a similar shape to a battery belonging to the source domain, a new predictive model M2 is generated by using the information of the prediction model M1 of the source domain. By using the main factors selected in the M1 from the target domain where the data of new batteries are collected and stored and the characteristics of the model, the model M2 with high prediction performance is generated in a short period of time even with small-sized data, and then used for predicting whether the battery is normal/defective.

An exemplary embodiment of the present invention may provide a Battery Management System (BMS) apparatus including the apparatus for predicting the low-voltage failure of the secondary battery according to the present invention. That is, in the exemplary embodiment of the present invention, the apparatus for predicting the low-voltage failure of the secondary battery may be used in the BMS apparatus.

An exemplary embodiment of the present invention may provide the BMS apparatus including a capacity measuring device including the first training data input unit, the first measurement data input unit, the first data learning unit, the first verification unit, the model transferring unit, the second training data input unit, the second measurement data input unit, the second data learning unit, and the second output unit.

In the present specification, the "BMS apparatus" means any form of interface that includes a battery management system.

An exemplary embodiment of the present invention may provide a mobile device including the management system apparatus according to the present application.

In the present specification, the "mobile device" means a device that can move itself or can be easily transported by a user, such as an electric vehicle or mobile device.

The exemplary embodiment of the present invention may provide the BMS apparatus in which at least one of the first training data input unit, the first measurement data input unit, the first data learning unit, the first verification unit, the model transferring unit, the second training data input unit, the second measurement data input unit, the second data learning unit, and the second output unit of the BMS apparatus is remotely controlled.

The exemplary embodiment of the present invention may provide the BMS apparatus in which two or more of the first training data input unit, the first measurement data input unit, the first data learning unit, the first verification unit, the model transferring unit, the second training data input unit, the second measurement data input unit, the second data learning unit, and the second output unit of the BMS apparatus are remotely controlled.

The exemplary embodiment of the present invention may provide the BMS apparatus in which all of the first training data input unit, the first measurement data input unit, the first data learning unit, the first verification unit, the model transferring unit, the second training data input unit, the second measurement data input unit, the second data learning unit, and the second output unit of the BMS apparatus are remotely controlled.

The exemplary embodiment of the present invention may provide the BMS apparatus in which at least one of the first training data input unit, the first measurement data input unit, the first data learning unit, the first verification unit, the first output unit, the model transferring unit, the second training data input unit, the second measurement data input unit, the second data learning unit, and the second output unit of the BMS apparatus is remotely controlled.

In the exemplary embodiment of the present invention, the BMS apparatus may include one or more interfaces, and one or more of the interfaces are remotely controlled.

In the present specification, the meaning of "remotely controlled" means that the interfaces, such as the input unit, the learning unit, and the output unit are located outside the BMS apparatus and perform their functions by transmitting or receiving data and signals between the interfaces through communication. As a method of the remote control, an example is, but is not limited to, a method of placing some of the interfaces on a cloud server and managing to perform the function by transmitting or receiving data and signals between the interfaces through communication, and any method capable of performing the function outside of the BMS apparatus is applicable to the configuration of the present invention.

When the interface of some or all of the interfaces of the apparatus are remotely controlled, the weighting factor of the BMS apparatus may be reduced, so that it is easy to apply the BMS apparatus to a mobile device, and a specific main computer or cloud server is used, so that it is easy to manage data and the like generated in the process of using the apparatus in an integrated manner.

In addition, when some of the interfaces of the apparatus are remotely controlled, it is possible to lower the specifications required for memory for data storage, computation, information processing, and the like in relation to computer hardware (H/W) and simplify the configuration, thereby reducing the cost related to computer hardware installed in the mobile device.

Further, in the exemplary embodiment of the present invention, at least one of the first training data input unit, the first measurement data input unit, the first data learning unit, the first verification unit, the model transferring unit, the second training data input unit, the second measurement data input unit, the second data learning unit, and the second output unit of the BMS apparatus may be embedded in the mobile device.

Further, in the exemplary embodiment of the present invention, two or more of the first training data input unit, the first measurement data input unit, the first data learning unit, the first verification unit, the model transferring unit, the second training data input unit, the second measurement data input unit, the second data learning unit, and the second output unit of the BMS apparatus may be embedded in the mobile device.

Further, in the exemplary embodiment of the present invention, all of the first training data input unit, the first measurement data input unit, the first data learning unit, the first verification unit, the model transferring unit, the second training data input unit, the second measurement data input unit, the second data learning unit, and the second output unit of the BMS apparatus may be embedded in the mobile device.

Further, in the exemplary embodiment of the present invention, at least one of the first training data input unit, the first measurement data input unit, the first data learning unit, the first verification unit, the first output unit, the model transferring unit, the second training data input unit, the second measurement data input unit, the second data learning unit, and the second output unit of the BMS apparatus may be embedded in the mobile device.

In the exemplary embodiment of the present invention, the BMS apparatus may include one or more interfaces, and one or more of the interfaces may be embedded in the mobile device.

The exemplary embodiment of the present invention may provide the mobile device in which all of the training data input unit, the measurement data input unit, the data learning unit, the reference value storage unit, and a capacity status diagnosis unit are embedded in the mobile device.

In the present specification, the meaning of "embedded in the mobile device" means that the interface of the input unit, the learning unit, and the output unit corresponds to one of the components of the mobile device.

When some or all of the devices are embedded in the mobile device, it has the advantage that safety issues due to communication problems do not arise.

If there are other interfaces that can be added, each interface may be remotely controlled or embedded in the mobile device.

More specifically, the BMS refers to a system that performs capacity matching and cell balancing, controls charging or discharging of the battery, and controls and manages the overall state of the battery, such as the remaining amount of the battery and the failure of the battery, when the battery is installed in an electric vehicle, mobile device, and the like and used as a power source. The BMS may be applied to one or more batteries. That is, the BMS is typically applied to multiple batteries, but may be applied to a single battery, and the BMS may be individually applied to each battery.

Data generated by the BMS apparatus may also be managed integrally as described above.

When the apparatus for predicting the low-voltage failure of the secondary battery according to the present invention is applied to the BMS apparatus, it is possible to improve the accuracy of measuring the capacity of the battery, thereby improving the accuracy of diagnosing the state of the battery and predicting the life of the battery. In other words, as one or more batteries are installed in an electric vehicle, a mobile device, and the like and used as a power source, it is possible to more accurately and efficiently control the battery when the overall management of the battery, including capacity matching and cell balancing, is performed by the BMS.

An exemplary embodiment of the present invention provides a method of predicting a low-voltage failure of a secondary battery, the method including: inputting first training data of a secondary battery measured during a specific time period of charging, discharging, and resting processes of an individual secondary battery selected as a first training target; generating a low-voltage prediction model of a first secondary battery by performing machine learning on the first training data and selecting a main factor from the first training data; inputting first measurement data of the secondary battery selected during a specific time period of charging, discharging, and resting processes of a secondary battery selected as a first prediction target; comparing a low-voltage determination prediction result of the secondary battery in which the first measurement data is applied to the generated low-voltage prediction model of the first secondary battery with actual low-voltage determination prediction result of the secondary battery of the first measurement data to verify and optimize the low-voltage prediction model of the first secondary battery; transferring the optimized low-voltage prediction model of the first secondary battery; inputting second training data of a secondary battery measured during a specific time period of charging, discharging, and resting processes of an individual secondary battery selected as a second training target; generating a low-voltage prediction model of a second secondary battery by performing machine learning on the low-voltage prediction model of the optimized transferred first secondary battery and the second training data; inputting second measurement data of a secondary battery selected during a specific time period of charging, discharging, and resting processes of a secondary battery selected as a second prediction target; and outputting a low-voltage determination prediction result of the secondary battery in which the second measurement data is applied to the low-voltage prediction model of the second secondary battery generated from the second data learning unit, in which process conditions of the secondary batteries selected as the first training target and the first prediction target are different from process conditions of the secondary battery selected as the second training target and the second prediction target.

The method of predicting the low-voltage failure of the secondary battery of the present invention may reduce the time required to accumulate or collect data to establish determination criteria for predicting and diagnosing (prognosis) whether a low-voltage failure occurs or a large amount of new data whenever a battery model changes or manufacturing conditions and the like change, so that when the apparatus for predicting the low-voltage failure of the secondary battery of the present invention is applied to secondary batteries with different process conditions, it is possible to reduce the time required to determine a low-voltage failure of a secondary battery and minimize the risk of failure by detecting and responding to a low-voltage failure earlier.

The first training data of the secondary battery, the first measurement data of the secondary battery, the second training data, and the second measurement data of the secondary battery of the method of predicting the low-voltage failure of the secondary battery according to the exemplary embodiment of the present invention refer to, but are not limited to, at least one measurement value selected from a voltage measurement value of the battery, a current measurement value of the battery, an impedance measurement value of the battery, a temperature measurement value of the battery, a capacity measurement value of the battery, and a power measurement value of the battery that are measured in the charging, discharging, and resting processes of the secondary battery independently.

The machine leaning performed on the first training data and the second training data of the method of predicting the low-voltage failure of the secondary battery according to the exemplary embodiment of the present invention may be, each independently, applying one or more methods selected from, but not limited to, decision trees, random forests, neural networks, deep neural networks, support vector machines, and gradient boosting machines.

The verifying and optimizing of the low-voltage prediction model of the first secondary battery of the method of predicting the low-voltage failure of the secondary battery according to the exemplary embodiment of the present invention includes finding an optimal value of the weighting factor k that may maximize the performance of the low voltage prediction model of the first secondary battery, and the optimal value of the weighting factor k may mean a value that may minimize a Misclassification Error Rate (MER).

The method of predicting the low-voltage failure of the secondary battery according to the exemplary embodiment of the present invention may further include outputting a low-voltage determination prediction result of the secondary battery in which the first measurement data is applied to the low-voltage prediction model of the first secondary battery generated from the first data learning unit.

The method of predicting the low-voltage failure of the secondary battery according to the exemplary embodiment of the present invention may further include verifying the low-voltage prediction mode of the second secondary battery by comparing the low voltage determination prediction result of the secondary battery in which the second measurement data is applied to the low voltage prediction model of the second secondary battery generated by the second data learning unit and the actual low voltage determination result of the secondary battery of the second measurement data.

In the exemplary embodiment of the present invention, the method of predicting the low-voltage failure of the secondary battery may be a method used in the BMS. That is, in the exemplary embodiment of the present invention, the BMS may perform the function of the BMS by utilizing the method of predicting the low-voltage failure of the secondary battery according to the present invention.

Even in this case, as described above, as one or more batteries are installed in an electric vehicle, a mobile device, and the like and used as a power source, it is possible to more accurately and efficiently control the battery when the overall management of the battery, including capacity matching and cell balancing, is performed by the BMS.

In the present specification, the description applied to the apparatus for predicting the low-voltage failure of the secondary battery according to the exemplary embodiment of the present invention is also applicable to the method of predicting the low-voltage failure of the secondary battery according to the exemplary embodiment of the present invention.

The apparatus and the method of predicting the low-voltage failure of the secondary battery according to the present invention may improve accuracy of the determination of the low-voltage failure of the secondary battery, thereby saving process costs.

Further, the apparatus and the method according to the exemplary embodiments of the present invention may reduce the time required to determine a low-voltage failure of a secondary battery and minimize the risk according to a failure by enabling early detection and response to low-voltage failures.

An exemplary embodiment of the present invention provides a computer program stored in a recording medium executing the method of predicting the low-voltage failure of the secondary battery according to the present invention. The above description of the method of predicting the low-voltage failure of the secondary battery may be equally applicable, except that each operation of the method of predicting the low-voltage failure of the secondary battery is stored on a recording medium in the form of a computer program.

[Mode for Carrying out the Invention]

More specifically, the process of predicting a low-voltage failure of a secondary battery is described as follows.

<Example>

In a first condition, the 50,000 secondary batteries to be learned were placed on a module, pack, or tray, voltage measurement values of the batteries, current measurement values of the batteries, impedance measurement values of the batteries, temperature measurement values of the batteries, capacity measurement values of the batteries, and power measurement values of the batteries during charging, discharging, and resting processes were measured and collected, and the values were stored in a storage medium as first training data and first measurement data corresponding to source data.

Then, machine learning was performed on the 50,000 data of the secondary battery by applying machine learning to the first training data to generate a low-voltage prediction model M1 of a first secondary battery and select main factors in the first training data.

A value of weighting factor K for minimizing an MER was calculated by comparing a low-voltage determination prediction result of the secondary battery in which the first measurement data is applied to the low-voltage prediction model of the first secondary battery generated from the first data learning unit with an actual low-voltage determination prediction result of the secondary battery of the first measurement data. In the present exemplary embodiment, as can be seen from FIG. 8, it can be seen that the lowest MER was obtained at k=0.55.

In a second condition different from the first condition, the 10,000 to 50,000 secondary batteries to be learned were placed on a module, pack, or tray, voltage measurement values of the batteries, current measurement values of the batteries, impedance measurement values of the batteries, temperature measurement values of the batteries, capacity measurement values of the batteries, and power measurement values of the batteries during charging, discharging, and resting processes were measured and collected, and the values were stored in a storage medium as second training data and second measurement data corresponding to the source data.

The low voltage prediction model M1 of the first secondary battery that reflects the value of the weighting factor k to minimize the MER generated earlier and the value of the weighting factor k to minimize the MER were transferred, machine learning was performed using the transferred low voltage prediction model M1 of the first secondary battery and the second training data, and a low voltage prediction model M2 of the second secondary battery was generated. The process of transferring the M1 and performing machine learning is called Transfer Learning (TL) .

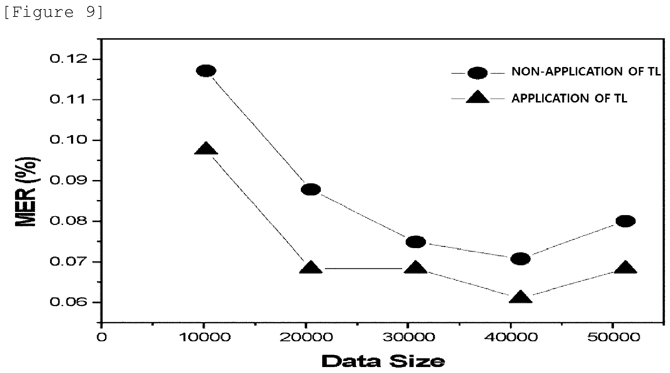

The MER was calculated by reflecting the second measurement data to the low-voltage prediction model of the second secondary battery. The result is represented in FIG. 9 below.

<Comparative Example>

In the second condition that is the same as that of the Example, the 10,000 to 50,000 secondary batteries to be learned were placed on a module, pack, or tray, voltage measurement values of the batteries, current measurement values of the batteries, impedance measurement values of the batteries, temperature measurement values of the batteries, capacity measurement values of the batteries, and power measurement values of the batteries during charging, discharging, and resting processes were measured and collected, and the values were stored in a storage medium as training data and measurement data corresponding to source data.

The machine learning was performed by using the training data to generate a low-voltage prediction model M3 of the secondary battery. In other words, unlike the exemplary embodiment, the optimal value of weighting factor k was not found and Transfer Learning (TL) was not performed.

In this case, the MER was calculated by reflecting the measurement data to the low-voltage prediction model M3 of the secondary battery. The result is represented in FIG. 9 below.

From FIG. 9, which shows the results of the example and the comparative example, it can be seen that the apparatus and the method of predicting the low-voltage failure of the secondary battery according to the present invention have excellent prediction accuracy. In particular, it can be seen that the apparatus and the method of predicting the low-voltage failure of the secondary battery according to the present invention include the transfer learning process, so that it is possible to generate a model exhibiting performance with the low MER from a much smaller number of training data of the batteries. That is, it can be seen that in the case including the transfer learning process, it is possible to generate a model with high prediction accuracy from a much smaller number of training data of the batteries.

The above result that the apparatus and the method according to the exemplary embodiments of the present invention may improve the accuracy of the determination of the low-voltage failure of the secondary battery, which may result in cost savings in the process. For example, by preventing the problems in which good batteries are erroneously determined to have a failure and discarded or defective batteries are erroneously determined to be good and shipped out, it is possible to save costs.

Further, the result shows that the apparatus and the method according to the exemplary embodiments of the present invention may reduce the time required to accumulate or collect data to establish determination criteria for predicting and diagnosing (prognosis) whether a low-voltage failure occurs or a large amount of new data whenever a battery model changes or manufacturing conditions and the like change. That is, it is possible to reduce the time required to determine a low-voltage failure of a secondary battery and minimize the risk of failure by detecting and responding to a low-voltage failure earlier.

## Claims

1. An apparatus for predicting a low-voltage failure of a secondary battery, the apparatus comprising:

   a first training data input unit for receiving first training data of a secondary battery measured during a specific time period of charging, discharging, and resting processes of an individual secondary battery selected as a first training target;
   a first measurement data input unit for receiving first measurement data of a secondary battery selected during a specific time period of the charging, discharging, and resting processes of a secondary battery selected as a first prediction target;

a first data learning unit for generating a low-voltage prediction model of a first secondary battery by performing machine learning on the first training data of the secondary battery input to the first training data input unit and selecting a main factor among the first training data;

a first verification unit for comparing a low-voltage determination prediction result of the secondary battery in which the first measurement data is applied to the low-voltage prediction model of the first secondary battery generated from the first data learning unit with an actual low-voltage determination prediction result of the secondary battery of the first measurement data and finding an optimal value of a weighting factor k that maximizes performance of the low-voltage prediction model of the first secondary battery to verify and optimize the low-voltage prediction model of the first secondary battery;

a model transferring unit for receiving the optimized low voltage prediction model of the first secondary battery and the optimal value of the weighting factor k;

a second training data input unit for receiving second training data of a secondary battery measured during a specific time period of charging, discharging, and resting processes of an individual secondary battery selected as a second training target;

a second measurement data input unit for receiving second measurement data of a secondary battery selected during a specific period of the charging, discharging, and resting processes of a secondary battery selected as a second prediction target;

a second data learning unit for generating a low-voltage prediction model of a second secondary battery by performing machine learning on the optimized low-voltage prediction model of the first secondary battery transferred to the model transferring unit and the second training data of the secondary battery input to the second training data input unit; and

a second output unit for outputting a low-voltage determination prediction result of the secondary battery in which the second measurement data is applied to the low-voltage prediction model of the second secondary battery generated from the second data learning unit,

wherein process conditions of the secondary battery selected as the first training target and the first prediction target are different from process conditions of the secondary battery selected as the second training target and the second prediction target.

2. The apparatus of claim 1, wherein each of the first training data of the secondary battery, the first measurement data of the secondary battery, the second training data, and the second measurement data of the secondary battery refer to one or more measurement values selected from a voltage measurement value of the battery, a current measurement value of the battery, an impedance measurement value of the battery, a temperature measurement value of the battery, a capacity measurement value of the battery, and a power measurement value of the battery that are measured in the charging, discharging, and resting processes of the secondary battery independently.

3. The apparatus of claim 1, wherein each of the machine learning of the first data learning unit and the second data learning unit independently apply one or more methods selected from decision tree, random Forest, neural network, deep neural network, support vector machine, and gradient boosting machine.

4. The apparatus of claim 1, wherein the optimal value of the weighting factor k means a value that minimizes a Misclassification Error Rate (MER).

5. The apparatus of claim 1, further comprising:
a first output unit for outputting a low-voltage determination prediction result of the secondary battery in which the first measurement data is applied to the low-voltage prediction model of the first secondary battery generated from the first data learning unit.

6. The apparatus of claim 1, further comprising:
a second verification unit for verifying the low voltage prediction model of the second secondary battery by comparing the low voltage determination prediction result of the secondary battery in which the second measurement data is applied to the low voltage prediction model of the second secondary battery generated by the second data learning unit and the actual low voltage determination result of the secondary battery of the second measurement data.

7. A method of predicting a low-voltage failure of a secondary battery, the method comprising:

inputting first training data of a secondary battery measured during a specific time period of charging, discharging, and resting processes of an individual secondary battery selected as a first training target;
generating a low-voltage prediction model of a first secondary battery by performing machine learning on the first training data and selecting a main factor among the first training data;

inputting first measurement data of a secondary battery selected during a specific time period of the charging, discharging, and resting processes of a secondary battery selected as a first prediction target;

comparing a low-voltage determination prediction result of the secondary battery in which the first measurement data is applied to the low-voltage prediction model of the first secondary battery generated from the first data learning unit with an actual low-voltage determination prediction result of the secondary battery of the first measurement data and finding an optimal value of a weighting factor k that maximizes performance of the low-voltage prediction model of the first secondary battery to verify and optimize the low-voltage prediction model of the first secondary battery;

transferring the optimized low voltage prediction model of the first secondary battery and the optimal value of the weighting factor k;

inputting second training data of a secondary battery measured during a specific time period of charging, discharging, and resting processes of an individual secondary battery selected as a second training target;

generating a low-voltage prediction model of a second secondary battery by performing machine learning on the transferred optimized low-voltage prediction model of the first secondary battery and the second training data;

inputting second measurement data of a secondary battery selected during a specific period of the charging, discharging, and resting processes of a secondary battery selected as a second prediction target; and

outputting a low-voltage determination prediction result of the secondary battery in which the second measurement data is applied to the low-voltage prediction model of the second secondary battery generated from the second data learning unit,

wherein process conditions of the secondary battery selected as the first training target and the first prediction target are different from process conditions of the secondary battery selected as the second training target and the second prediction target.

8. The method of claim 7, wherein each of the first training data of the secondary battery, the first measurement data of the secondary battery, the second training data, and the second measurement data of the secondary battery refer to one or more measurement values selected from a voltage measurement value of the battery, a current measurement value of the battery, an impedance measurement value of the battery, a temperature measurement value of the battery, a capacity measurement value of the battery, and a power measurement value of the battery that are measured in the charging, discharging, and resting processes of the secondary battery independently.

9. The method of claim 7, wherein each of the machine learning of the first training data and the second training data independently apply one or more methods selected from decision tree, random Forest, neural network, deep neural network, support vector machine, and gradient boosting machine.

10. The method of claim 7, wherein the optimal value of the weighting factor k means a value that minimizes a Misclassification Error Rate (MER).

11. The method of claim 7, further comprising:
outputting a low-voltage determination prediction result of the secondary battery in which the first measurement data is applied to the low-voltage prediction model of the first secondary battery generated from the first data learning unit.

12. The method of claim 7, further comprising:
verifying the low voltage prediction model of the second secondary battery by comparing the low voltage determination prediction result of the secondary battery in which the second measurement data is applied to the low voltage prediction model of the second secondary battery generated by the second data learning unit and the actual low voltage determination result of the secondary battery of the second measurement data.

13. A Battery Management System (BMS) apparatus including the apparatus for predicting the low-voltage failure of the secondary battery of any one of claims 1 to 6.

14. The BMS apparatus of claim 13, wherein at least one of the first training data input unit, the first measurement data input unit, the first data learning unit, the first verification unit, the model transferring unit, the second training data input unit, the second measurement data input unit, the second data learning unit, and the second output unit of the BMS apparatus is remotely controlled.

15. A mobile device including the BMS apparatus of claim 14.

16. The mobile device of claim 15, wherein at least one of the first training data input unit, the first measurement data input unit, the first data learning unit, the first verification unit, the model transferring unit, the second training data input unit, the second measurement data input unit, the second data learning unit, and the second output unit of the BMS apparatus is embedded in the mobile device.

17. A computer program stored in a recording medium executing the method of predicting the low-voltage failure of the secondary battery of any one of claims 7 to 12.

[Figure 1]

**ACTUAL RESULT**

|  | Normal (Positive) | Defective (Negative) |
|---|---|---|
| **Normal (Positive)** | TP | FP |
| **Defective (Negative)** | FN | TN |

PREDICTION RESULT

[Figure 2]

```
MEASURE PRIMARY VOLTAGE (OR OCV)
              |
             ...
              |
      MEASURE NTH VOLTAGE (OR OCV)
              |
  CALCULATE VOLTAGE DROP CHARACTERISTIC VALUE
              |
      VOLTAGE DROP >              No
      DETERMINATION      ---------------->   NORMAL
      CRITERIA?
              |
            Yes
              |
      LOW-VOLTAGE FAILURE
              |
             END
```

[Figure 3]

[Figure 4]

[Figure 5]

Dataset 1
(D1)

ML

Source
Domain

TL

Target
Domain

Dataset 2
(D2)

[Figure 6]

DATA COLLECTING

UNIT

MACHINE LEARNING

UNIT

DATA STORAGE

UNIT

NORMAL/DEFECTIVE

DETERMINATION

UNIT

[Figure 7]

[Figure 8]

k = Probabilistic threshold
of weighting factor (0 < k < 1)

[Figure 9]

| INTERNATIONAL SEARCH REPORT | International application No. |
|---|---|
| | **PCT/KR2022/008648** |

### A. CLASSIFICATION OF SUBJECT MATTER

**G01R 31/367**(2019.01)i; **G01R 31/392**(2019.01)i; **G01R 31/36**(2006.01)i; **G01R 31/382**(2019.01)i

According to International Patent Classification (IPC) or to both national classification and IPC

### B. FIELDS SEARCHED

Minimum documentation searched (classification system followed by classification symbols)

G01R 31/367(2019.01); G01R 31/36(2006.01); G01R 31/392(2019.01); G06N 20/00(2019.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 이차전지(secondary battery), 저전압(low voltage), 예측(estimating), 학습(learning)

### C. DOCUMENTS CONSIDERED TO BE RELEVANT

| Category* | Citation of document, with indication, where appropriate, of the relevant passages | Relevant to claim No. |
|---|---|---|
| A | KR 10-2009-0020362 A (LG CHEM, LTD.) 26 February 2009 (2009-02-26)<br>See paragraphs [0058]-[0060] and claims 2 and 9. | 1-17 |
| A | KR 10-2015-0049526 A (LG CHEM, LTD.) 08 May 2015 (2015-05-08)<br>See claims 1-5. | 1-17 |
| A | JP 2014-206499 A (SHINDENGEN ELECTRIC MFG CO., LTD.) 30 October 2014 (2014-10-30)<br>See claims 1-7. | 1-17 |
| A | US 2021-0103003 A1 (CONTINENTAL AUTOMOTIVE SYSTEMS, INC.) 08 April 2021 (2021-04-08)<br>See paragraphs [0013]-[0021]. | 1-17 |
| A | KR 10-2021-0016154 A (S.J TECH CO., LTD.) 15 February 2021 (2021-02-15)<br>See paragraphs [0036]-[0118]. | 1-17 |

| ☐ Further documents are listed in the continuation of Box C. | ☑ See patent family annex. |
|---|---|

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **13 October 2022** | **13 October 2022** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

## INTERNATIONAL SEARCH REPORT
### Information on patent family members

International application No.

**PCT/KR2022/008648**

| Patent document cited in search report | | | Publication date (day/month/year) | Patent family member(s) | | | Publication date (day/month/year) |
|---|---|---|---|---|---|---|---|
| KR | 10-2009-0020362 | A | 26 February 2009 | CN | 101803104 | A | 11 August 2010 |
| | | | | CN | 101803104 | B | 09 January 2013 |
| | | | | CN | 101809456 | A | 18 August 2010 |
| | | | | CN | 101809456 | B | 13 November 2013 |
| | | | | EP | 2188642 | A2 | 26 May 2010 |
| | | | | EP | 2188642 | B1 | 06 March 2019 |
| | | | | EP | 2206191 | A2 | 14 July 2010 |
| | | | | EP | 2206191 | B1 | 04 March 2015 |
| | | | | JP | 2010-538246 | A | 09 December 2010 |
| | | | | JP | 2010-539473 | A | 16 December 2010 |
| | | | | JP | 5005814 | B2 | 22 August 2012 |
| | | | | JP | 5313250 | B2 | 09 October 2013 |
| | | | | KR | 10-0911316 | B1 | 11 August 2009 |
| | | | | PL | 2188642 | T3 | 30 August 2019 |
| | | | | US | 2010-0312733 | A1 | 09 December 2010 |
| | | | | US | 2011-0191278 | A1 | 04 August 2011 |
| | | | | US | 8412658 | B2 | 02 April 2013 |
| | | | | US | 9255973 | B2 | 09 February 2016 |
| | | | | WO | 2009-025512 | A2 | 26 February 2009 |
| | | | | WO | 2009-025512 | A3 | 23 April 2009 |
| | | | | WO | 2009-035288 | A2 | 19 March 2009 |
| | | | | WO | 2009-035288 | A3 | 07 May 2009 |
| KR | 10-2015-0049526 | A | 08 May 2015 | KR | 10-1802002 | B1 | 27 November 2017 |
| JP | 2014-206499 | A | 30 October 2014 | JP | 6250298 | B2 | 20 December 2017 |
| US | 2021-0103003 | A1 | 08 April 2021 | US | 11209492 | B2 | 28 December 2021 |
| KR | 10-2021-0016154 | A | 15 February 2021 | KR | 10-2238248 | B1 | 12 April 2021 |

Form PCT/ISA/210 (patent family annex) (July 2019)

**EP 4 300 109 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210079389
- KR 1020150049528